# EUROPEAN PATENT SPECIFICATION

(11) **EP 2 137 739 B1**
(45) Date of publication and mention of the grant of the patent: **01.11.2017**
(21) Application number: 08746767.6
(22) Date of filing: 24.04.2008
(51) Int. Cl.: H01B 1/22, H01L 31/00

(54) **THICK FILM CONDUCTOR FORMULATIONS COMPRISING SILVER AND NICKEL OR SILVER AND NICKEL ALLOYS AND SOLAR CELLS MADE THEREFROM**
DICKSCHICHTLEITERFORMULIERUNGEN MIT SILBER UND NICKEL ODER SILBER- UND NICKELLEGIERUNGEN SOWIE DARAUS HERGESTELLTE SOLARZELLEN
FORMULATIONS DE CONDUCTEUR À COUCHE ÉPAISSE COMPRENANT DE L'ARGENT ET DU NICKEL OU DES ALLIAGES D'ARGENT ET DE NICKEL ET CELLULES SOLAIRES PRÉPARÉES À PARTIR DE CELLES-CI

(30) Priority: 25.04.2007 US 913819 P
(43) Date of publication of application: 30.12.2009
(73) Proprietor: Heraeus Precious Metals North America Conshohocken LLC, West Conshohocken, PA 19428 (US)
(72) Inventor: SHAIKH, Aziz, S., San Diego, CA 92127 (US); KUMAR, Umesh, Carlsbad, CA 92009 (US); WHITFORD, Virginia, L., San Diego, CA 92107 (US); SRIDHARAN, Srinivasan, Strongsville, OH 44136 (US)
(74) Representative: Gille Hrabal
(86) International application number: PCT/US2008/061406
(87) International publication number: WO 2008/134417

(56) References cited:
- WO-A1-02/082466
- WO-A2-2006/132766
- US-A1- 2006 162 770
- US-B2- 7 115 218
- DATABASE WPI Week 199120 Thomson Scientific, London, GB; AN 1991-143598 XP002693848, & JP 3 078906 A (FURUKAWA ELECTRIC CO LTD) 4 April 1991 (1991-04-04)

## Description

### FIELD OF THE INVENTION

This invention relates to a paste composition and a method of making contacts for solar cells as well as other related components used in fabricating photovoltaic cells. In particular, the invention relates to thick film pastes comprising nickel or nickel alloys and silver for use in solar cell contacts and other applications.

### BACKGROUND OF THE INVENTION

Solar cells are generally made of semiconductor materials, such as silicon (Si), which convert sunlight into useful electrical energy. Solar cells are typically made of thin wafers of Si in which the required PN junction is formed by diffusing phosphorus (P) from a suitable phosphorus source into a P-type Si wafer. The side of silicon wafer on which sunlight is incident is in general coated with an anti-reflective coating (ARC) to prevent reflective loss of incoming sunlight, and thus to increase the efficiency of the solar cell. A two dimensional electrode grid pattern known as a front contact makes a connection to the N-side of silicon, and a coating of aluminum (Al) on the other side (back contact) makes connection to the P-side of the silicon. These contacts are the electrical outlets from the PN junction to the outside load.

Front contacts of silicon solar cells are formed by screen-printing a thick film paste. Typically, the paste contains approximately 75-80 wt% of fine silver particles, 1-5 wt% of glass and 15-20 wt% organics. After screen-printing, the wafer and paste are fired in air, typically at furnace set temperatures of about 650 to about 1000°C for few a seconds in a furnace. A suitable firing profile will be selected to remove organics, to soften/melt the glass, and to fuse/sinter the silver particles to form a dense solid, thereby forming highly conductive silver traces. During this step, glass softens, melts and reacts with the anti-reflective coating, etches the silicon surface, and facilitates the formation of intimate silicon-silver contact. Silver deposits on silicon as islands. The shape, size, and number of silicon-silver islands determine the efficiency of electron transfer from silicon to the outside circuit.

### SUMMARY OF THE INVENTION

The invention provides thick film pastes for use in producing solar cell contacts according to claim 1.

A further embodiment of the invention is a solar cell including a front contact, said front contact formed by firing a paste composition according to claim 1.

A further embodiment of the invention relates to a process of making a solar cell contact, the process comprising (a) applying a paste to a silicon wafer, wherein the paste comprises (i) a glass portion and (ii) a conductive metal portion, said conductive metal portion comprising (1) from about 10 to about 99 wt% silver and (2) from about 1 to about 90 wt% of a nickel alloy selected from the group consisting of a nickel-aluminum alloy, a nickel-chromium alloy, and a nickel-aluminum-chromium alloy, and combinations thereof, and (b) firing the silicon wafer at a time and temperature sufficient to sinter the metal portion and fuse the glass portion.

The glass frits used to form the glass portion are not critical; a variety of lead containing and lead-free glasses may be utilized in the paste compositions of the invention. The glasses can be partially crystallizing types. Also, the pastes of the invention may be fired in air, no special atmosphere is required.

The compositions and methods of the invention overcome the drawbacks of the prior art by facilitating optimized interaction, bonding, and contact formation between contact components, typically nickel, silver and silicon, through the glass medium. A conductive paste containing glass, silver, and nickel is printed on a silicon wafer, and fired to fuse the glass and sinter the metal therein. Upon firing, conductive islands are formed providing conductive bridges between bulk paste and silicon wafer. Leaded glasses allow low firing temperatures owing to their excellent flow characteristics relatively at low temperatures. However, suitable lead free glasses may be used to allow low firing temperatures while avoiding environmental concerns relating to lead. Cadmium-free glasses may be used for similar reasons.

Methods of making solar cells using any paste composition herein are also envisioned. In addition to solar cells, the pastes of the invention can be used to produce a variety of circuit devices.

The foregoing and other features of the invention are hereinafter more fully described and particularly pointed out in the claims, the following description setting forth in detail certain illustrative embodiments of the invention.

### BRIEF DESCRIPTION OF THE DRAWINGS

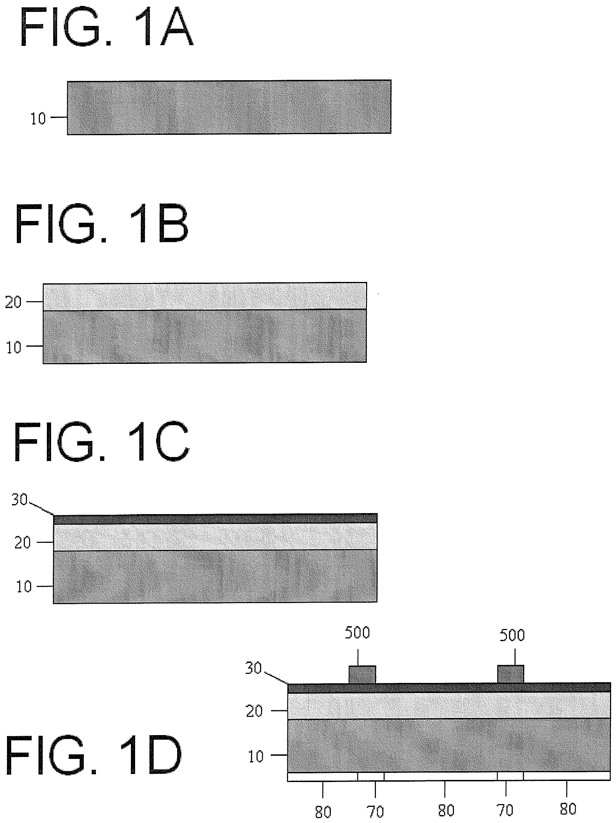

FIGS. 1A-1E provide a process flow diagram schematically illustrating the fabrication of a semiconductor device, for example, in a solar cell. Reference numerals shown in FIGS. 1A-1E are explained below.
10: p-type silicon substrate
20: n-type diffusion layer
30: front side passivation layer/ anti-reflective coating
40: p+ layer (back surface field, BSF)
70: silver or silver/nickel or silver/aluminum/nickel paste formed on backside
71: silver or silver/nickel or silver/aluminum/nickel back electrode, obtained by firing paste 70
80: aluminum or aluminum/nickel paste formed on backside
81: aluminum or aluminum/nickel back electrode formed by firing paste 80
500: front side silver/nickel paste
501: silver/nickel front electrode after firing paste 500 through ARC

### DETAILED DESCRIPTION OF THE INVENTION

The nickel/silver- and glass- containing thick film pastes of the invention are used to make front contacts for silicon-based solar cells to collect current generated by exposure to light, or back contacts to conduct electrons to an outside load. Cell electrical performance as measured by cell efficiency (η) and fill factor (FF) is strongly affected by the microstructure and the electrical properties of the nickel/silver/silicon interface. The electrical properties of the solar cell are also characterized by series resistance (R_{S}) and shunt resistance (R_{Sh}). The composition and microstructure of the front contact interface largely determine R_{S}. While the paste is generally applied by screen-printing, methods such as extrusion, pad printing, and hot melt printing may be used. Solar cells with screen-printed front contacts are fired to relatively low temperatures (550°C to 850°C wafer temperature; furnace set temperatures of 650°C to 1000°C) to form a low resistance contact between the N-side of a phosphorus doped silicon wafer and a nickel/silver based paste. The front contact pastes, before firing, include a metal portion comprising silver and nickel metals in one or more physical and chemical forms (powder, flake, colloid, oxide, salt, alloy). The pastes typically include a glass component, a vehicle, and/or other additives.

The sequence and rates of reactions occurring as a function of temperature are factors in forming the low resistance contact between the silver/nickel paste or silver/nickel-alloy paste and silicon wafer. The interface structure consists of multiple phases: substrate silicon, conductive islands, conductive metal precipitates within the insulating glass layer, and bulk silver/nickel paste or silver/nickel-alloy paste. The glass forms a nearly continuous layer between the silicon interface and the bulk silver/nickel paste or silver/nickel-alloy paste.

An embodiment of the invention is a thick film paste comprising a vehicle, a glass portion and a conductive metal portion, where the conductive metal portion comprises: (a) from about 10 to about 99 wt% silver and (b) from about 1 to about 90 wt% of a nickel alloy selected from the group consisting of a nickel-aluminum alloy, a nickel-chromium alloy, and a nickel-aluminum-chromium alloy, and combinations thereof.

If a nickel alloy is used, the thick film paste may include as little as about 10% by weight silver. Use of the nickel in the paste provides a distinct advantage since the cost of nickel is less than half of the cost of silver. Pastes herein including a large majority of the nickel alloy (over 85 wt% of the metal portion) and a minority of silver have been used to produce solar cells that perform as well as, or substantially as well as, prior art cells made with conventional pastes having a metal portion comprising over 90% by weight silver.

A further embodiment of the invention is a solar cell including a front contact, where the front contact is formed by firing a paste composition comprising a glass portion and a conductive metal portion. The conductive metal portion comprises silver and at least about 1 wt% nickel.

Yet another embodiment of the invention is a thick film paste comprising a metal portion comprising about 5 to about 85 wt% nickel; about 10 to about 80 wt% silver, and about 0.1 to about 10 wt% of a metal selected from the group consisting of aluminum, chromium, and combinations thereof.

Another embodiment of the invention is a thick film paste comprising (a) a glass portion including frit particles having a particle size no greater than about 2 microns, the glass portion including at least one partially crystallizing glass frit, and (b) a conductive metal portion comprising (i) from about from about 10 to about 99 wt% silver and (ii) from about 0.05 to about 90 wt% of a nickel alloy selected from the group consisting of a nickel-aluminum alloy, a nickel-chromium alloy, and a nickel-aluminum-chromium alloy, and combinations thereof.

Still another embodiment of the invention is a solar cell comprising a contact, wherein the contact comprises a metal portion comprising, prior to firing: about 5 to about 85 wt% nickel; about 10 to about 80 wt% silver, and about 0.1 to about 10 wt% of a metal selected from the group consisting of aluminum, chromium, and combinations thereof.

Still another embodiment is a solar cell front contact comprising silver, a nickel alloy, and aluminum.

A further embodiment of the invention relates to a process of making a solar cell contact, the process comprising (a) applying a paste to a silicon wafer, wherein the paste comprises (i) a glass portion and (ii) a conductive metal portion, said conductive metal portion comprising (1) from about 10 to about 99 wt% silver and (2) from about 1 to about 90 wt% of a nickel alloy selected from the group consisting of a nickel-aluminum alloy, a nickel-chromium alloy, and a nickel-aluminum-chromium alloy, and combinations thereof, and (b) firing the silicon wafer at a time and temperature sufficient to sinter the metal portion and fuse the glass portion.

Yet another embodiment of the invention is a process for making a solar cell contact, comprising (a) applying a paste to a silicon wafer, wherein the paste comprises (i) a glass portion and (ii) a conductive metal portion, said conductive metal portion comprising (1) silver and (2) at least about 1 wt% nickel, and (b) firing the silicon wafer at a time and temperature sufficient to sinter the metal portion and fuse the glass portion.

Solar cells include a front contact made from pastes including a mixture of constituents. These mixtures, prior to firing, comprise a metal portion, a glass portion, (i.e., one or more glass frits), and a vehicle, that is, an organics portion. Up to about 30 wt % of other (i.e., inorganic) additives, preferably up to about 25 wt % and more preferably up to about 10 wt%, may be included as needed. The metal portion of the paste composition according to the invention includes silver and nickel or silver and nickel alloys, or other compounds capable of providing silver and nickel or silver and a nickel alloy upon sufficient heating, such as, for example, oxides, salts, and organometallic compounds. Organics, which serve as binders, vehicles, wetting agents and thixotropes are also found in the paste compositions herein. Each of the major constituent types - metal, glass, organics, and additives - is detailed hereinbelow.

**Nickel Component.** Nickel metal is supplied to the pastes herein in the form of powders or flakes. Typically, when nickel metal is used, the nickel particle size is approximately in line with the silver particle size. This size equivalence is not necessary, and in some cases not desirable, when an alloy of nickel is used. The nickel may be provided in the form of pure nickel powder, nickel oxide, organonickel, colloidal nickel, or as nickel alloyed with one or more other metals including any or all of aluminum, chromium, silicon, iron, molybdenum, antimony, vanadium and niobium/tantalum. As is known in the art, the proportion of niobium and tantalum are given together owing to their tendency to intimately alloy/mix and difficulty in purifying one from the other.

The use of nickel provides surprising results in both front and back solar cell contacts. With respect to both front and back contacts, it is known that Ni powder, when heated in air beyond 300°C, oxidizes to form NiO. Electrical resistivity of densified Ni is several micro ohm-cm (i.e., a good conductor) whereas that of NiO is several kilo ohm-cm (i.e., an insulator). Thus, by substituting nickel or a nickel alloy for silver, one skilled in the art would expect degradation in electrical properties of a solar cell made with nickel or a nickel alloy in addition to silver. On the contrary, even when a substantial portion, such as a large plurality of silver is replaced with nickel, (for example, Table 8, no. 4), very good electrical properties were observed.

Similarly, with respect to front contacts, it is well known that aluminum in front contact silver formulations severely degrades electrical properties. Yet, surprisingly, applicants have found that the presence of Al in the form of a Ni-Al alloy did not degrade the electrical performance, and in some cases improved it.

Accordingly, an embodiment of the invention is a thick film paste including a nickel alloy comprising 1 to about 25 wt% aluminum, preferably 4 to 20 wt% aluminum, about 0 to about 30 wt% chromium, and nickel. In another embodiment of the invention, the paste may include a nickel-chromium alloy, the nickel-chromium alloy comprising 1 to 60 wt% chromium. A nickel-aluminum alloy may alternatively comprise 75 to 99 wt% nickel and 1 to 25 wt% aluminum, preferably 80 to 99 wt% nickel and 1 to 20 wt% aluminum, more preferably 80 to 96 wt% nickel and 4 to 20 wt% aluminum.

Instead of or in addition to a nickel-aluminum alloy, a nickel-chromium alloy may be present in the pastes, such nickel chromium alloy comprising 48 to 81 wt% nickel and 19 to 52 wt% chromium.

Another embodiment of the invention is a thick film paste, where the conductive metal portion thereof comprises from 20 to 90 wt% silver, (b) from 10 to 80 wt% of a nickel alloy selected from the group consisting of a nickel-aluminum alloy, a nickel-chromium alloy, and a nickel-aluminum-chromium alloy, and combinations thereof.

When a nickel-aluminum alloy is used, it may comprise 1 to 30 wt% aluminum and 70 to 99 wt% nickel. In yet another embodiment, in the paste of the invention, the conductive metal portion comprises (a) 37.5 to 75 wt% silver and (b) 25 to 62.5 wt% of a nickel alloy. In still another embodiment, the conductive metal portion of the paste comprises (a) 13.8 to 87.5 wt% silver and (b) 12.5 to 86.2 wt% of a nickel alloy selected from the group consisting of nickel-aluminum, nickel chromium, nickel-aluminum-chromium, and combinations thereof. In other embodiments, the nickel content should account for at least 5 wt% of the metal portion. In still other embodiments, the metal portion includes at least 7 wt% nickel, at least 8 wt% nickel, at least 10 wt% nickel or at least 15 wt% of the metal portion.

Any nickel alloy herein may further comprise an element selected from the group consisting of cobalt, iron, silicon, molybdenum, niobium, tantalum, manganese, vanadium, antimony, and combinations thereof. For example, certain embodiments may include at least one of the following: chromium: 1 to 30 wt%, preferably 5 to 25 wt%, more preferably 10 to 20 wt%; iron: 0.1 to 10 wt%, preferably 0.3 to 8 wt%, more preferably 1 to 5 wt%; silicon: 0.1 to 5 wt%, preferably 1 to 4 wt%, more preferably 1.5 to 3 wt%; molybdenum: 1 to 10 wt%, preferably 2 to 8 wt%, more preferably 3 to 7 wt%; manganese: 0.1 to 5 wt%, preferably 0.25 to 4 wt%; niobium + tantalum: 0.1 to 10 wt%, preferably 0.3 to 8 wt%, more preferably 1 to 5 wt%; vanadium: 0.5 to 8 wt%, preferably 1 to 7 wt%, more preferably 2 to 6 wt%; and antimony: 0.5 to 9 wt%, preferably 1 to 8 wt%, more preferably 2 to 6 wt%.

**Silver Component.** The source of the silver in the silver component can be one or more fine powders of silver metal, or alloys of silver. A portion of the silver can be added as silver oxide (Ag₂O) or as silver salts such as AgNO₃ or AgOOCCH₃ (silver acetate). Additionally, the silver may be coated with various materials such as phosphorus. Alternately, silver may be coated on glass. Or silver oxide can be dissolved in the glass during the glass melting/manufacturing process. The silver particles used in the paste may be spherical, flaked, or provided in a colloidal suspension, and combinations of the foregoing may be used. Suitable commercial examples of silver particles are spherical silver powder Ag3000-1, silver flakes SFCGED and SF-23, and colloidal silver suspension RDAGCOLB, all commercially available from Ferro Corporation, Cleveland, Ohio.

Silver Powders. Broadly, the conductive metal portion of the pastes herein include from 10 to 99 wt% silver powders. In other embodiments, the conductive metal portion comprises 13.8 to 87.5 wt% silver; 20 to 90 wt% silver, 20 to 80 wt% silver, or 37.5 to 75 wt% silver.

The metals and alloys used herein may be provided in a variety of forms, such as powder, flake, and colloid. The particles of the metals silver, nickel, aluminum, (Al alone being only in a back contact) and alloys containing combinations of silver, aluminum, nickel and nickel alloys, have an average size of less than 10 microns, preferably less than 5 microns, and more preferably less than 1 micron. Other embodiments may include metal or alloy particles having average sizes of less than 750 nm, less than 500 nm or less than 250 nm.

Examples of metal powders and flakes useful herein appear in Table 1. The average particle size for silver and nickel as used in the Examples below is one (1) micron. For the alloys, the finest commercially available materials, sold as 325 mesh grade, were used for the Experimental Examples herein. An entry lacking a percentage amount of an constituent indicates that the balance of the formulation is made up by that constituent (up to 100 wt%).

**Table 1: Metal Constituents**

| **No** | **Metal Powder** | **Product ID or Description** | **Vendor** |
|---|---|---|---|
| **1** | Silver Powder | 1 micron powder | Ferro Electronic Materials |
| **2** | Silver Flakes | 1 micron flake | Ferro Electronic Materials |
| **3** | Nickel | UNP 800 | Umicore |
| **4** | Ni-4% Al | Ni 357-6 | Praxair |
| **5** | Ni-5% Al | Ecka 302 | Ecka Granules |
| **6** | Ni-9% Al | Ecka 329 | Ecka Granules |
| **7** | Ni-10% Al | SB 81 | Sandvik Osprey |
| **8** | Ni-20% Al | Ecka 304 | Ecka Granules |
| **9** | Ni-20% Cr | Ni 105 | Praxair |
| **10** | Ni-22% Cr-10% Al | Ni 343 | Praxair |
| **11** | Ni-32% Cr- 12% Al | Ni 246-3 | Praxair |
| **12** | Ni-19% Cr- 1.2% Si | Ecka 514 | Ecka Granules |
| **13** | Ni-51% Cr-1.6% Si | Ecka 666 | Ecka Granules |
| **14** | Ni-21.5%Cr-2.3% Fe-9.2% Mo-3.4% Nb/Ta | IN 625 | Sandvik Osprey |
| **15** | Ni-25Co-19Cr-13.7Al-0.48Y | NiCoCrAlY | Ultrafine Powder |

Powder/flake vendor information: Ferro Electronic Materials, South Plainfield, NJ and Vista, CA. Ecka-Granules of America, Louisville, KY. Umicore Canada Inc., Fort Saskatchewan, AB, Canada. Sandvik Osprey Ltd., Neath UK. Praxair Surface Technologies, Indianapolis, IN. Ultrafine Powder Technology Inc., Woonsocket, RI.

**Paste Glasses.** The glass frits used herein are not critical. As an initial matter, the glass frits used in the pastes herein may intentionally contain lead and/or cadmium, or they may be devoid of intentionally added lead and/or cadmium. The glasses may be partially crystallizing or non-crystallizing. Partially crystallizing glasses are preferred. The following tables set forth glass frit compositions useful in the practice of the invention. An entry such as Y₂O₃ + Yb₂O₃ means that Y₂O₃ or Yb₂O₃ or a combination of the two is present in the specified amount. The following tables set forth several useful glass compositions.

**Table 2. Oxide frit constituents for front contact glasses in mole percent of total glass.**

| **Glass Composition** | **I** | **II** | **III** |
|---|---|---|---|
| **Constituent** | | | |
| **Bi₂O₃** | **5-85** | **15-80** | **50-80** |
| **SiO₂** | **1-70** | **2-45** | **15-35** |
| **ZnO** | **0-55** | **0.1-25** | **1-15** |
| **V₂O₅** | **0-30** | **0.1-25** | **1-15** |

**Table 3. Oxide frit constituents for back contact glasses in mole percent of total glass.**

| **Glass Composition** | **IV** | **V** | **VI** |
|---|---|---|---|
| **Constituent** | | | |
| **Bi₂O₃** | **5-65** | **5-55** | **10-40** |
| **SiO₂** | **15-70** | **20-70** | **30-65** |
| **B₂O_{3̅}** | **0-35** | **0.1-35** | **3-20** |
| **Alkali oxides** | **0-35** | **0.1-25** | **5-25** |

**Table 4. Leaded oxide frit constituents for front contacts in mole percent of total glass**

| **Glass Composition** | **VII** | **VIII** | **IX** |
|---|---|---|---|
| **Constituent** | | | |
| **PbO** | **15-75** | **25-66** | **30-64** |
| **SiO₂** | **5-50** | **15-40** | **20-35** |
| **ZnO** | **0-50** | **5-35** | **20-33** |
| **PbO+ZnO** | **15-80** | **20-75** | **25-65** |

**Table 5. Additional oxide frit constituents for embodiments of Tables 2, 3, and 4 in mole percent of the glass component**

| **Ranges** | **Broad** | **Intermediate** | **Narrow** |
|---|---|---|---|
| **Constituent** | | | |
| **Al₂O₃** | **0-15** | **1-11** | **2-10** |
| **Ta₂O₅ + Nb₂O₅** | **0.1-10** | **0.1-3** | **0.2-2** |
| **Sb₂O₅ +V₂O₅** | **0.1-10** | **0.1-3** | **0.2-2** |
| **ZrO₂** | **0.1-10** | **0.5-5** | **1-2** |
| **P₂O₅** | **0.1-8** | **1-5** | **2-4** |
| **MoO₃** | **0.1-3** | **0.5-2.5** | **0.7-2** |
| **HfO₂+In₂O₃+Ga₂O₃** | **0.1-15** | **1-10** | **3-8** |
| **Y₂O₃ + Yb₂O₃** | **0.1-10** | **1-8** | **3-8** |

A given embodiment need not contain all frit constituents as noted in Table 5, but various combinations are possible. Other specific embodiments may contain various amounts of the aforementioned constituents in mole percent as shown in Table 6. The oxide constituent amounts for an embodiment need not be limited to those in a single column such as II or V or VIII. Oxide ranges from different columns in the same table can be combined so long as the sum of those ranges includes 100 mol%. Similarly, the additional oxide constituents of Table 5 may be added in combinations of amounts from different columns so long as they, taken together with the oxides from Tables 2, 3, or 4, possibly add up to 100 mol%.

**Table 6: Further embodiments of glass compositions mole percent of the glass component.**

| Glass Composition | XIII | XIV | XV | XVI | XVII | XVIII | XIX | XX |
|---|---|---|---|---|---|---|---|---|
| Constituent | | | | | | | | |
| PbO | 58-64 | 25-40 | 58-64 | 26-34 | 58-66 | 58-66 | 58-70 | 58-66 |
| SiO₂ | 25-31 | 20-31 | 22-32 | 27-33 | 20-31 | 20-31 | 20-31 | 20-32 |
| ZnO | 0-10 | 5-34 | | 27-33 | | | | |
| Al₂O₃ | 2-11 | 4-10 | 1-10 | 5-11 | 1-9 | 1-9 | 1-11 | 1-9 |
| Ta₂O₅ | | 0-2 | | 0.1-2 | 0.1-2 | | | 0.1-4 |
| P₂O₅ | | | | | | | | 0.1-4 |
| HfO₂+In₂O₃ +Ga₂O₃ | | | 0.1-8 | | | | | |
| ZrO₂ | | | | | 0.1-5 | | 0.1-2 | 0.1-4 |
| B₂O_{3̅} | | | | | | 0-3 | | |
| Sb₂O₅ | | | | | | 0.1-3 | | |

Commercially available glasses having product numbers LF 256, EG 2964, and IP 530, all from Ferro Corporation are also suitable. Further suitable glass compositions include those in Table 7:

**Table 7. Partially crystallizing glass compositions for use in the pastes and solar cell contacts of the invention.**

| **Glass →** | **A** | **B** | **C** | **D** | **E** | **F** |
|---|---|---|---|---|---|---|
| | | | | | | |
| mole% | | | | | | |
| PbO | 61.6 | 31.3 | 61.5 | 62.6 | 58.9 | 61.9 |
| ZnO | | 30.0 | | | | |
| SiO₂ | 30.3 | 29.8 | 27.2 | 28.4 | 28.7 | 30.1 |
| Al₂O₃ | 3.3 | 8.0 | 5.6 | 5.0 | 7.7 | |
| B₂O_{3̅} | | | 2.4 | | | |
| Ta₂O₅ | | 0.9 | | 0.3 | | |
| ZrO₂ | 1.6 | | 2.0 | 1.2 | | |
| P₂O₅ | 3.3 | | | 2.5 | | |
| Sb₂O₅ | | | 1.4 | | | |
| Ga₂O₃ | | | | | | 8.0 |
| HfO₂ | | | | | 4.8 | |

**Inorganic/Other Additives.** Phosphorus can be added to the paste in a variety of ways to reduce the resistance of the front contacts. For example, certain glasses can be modified with P₂O₅ in the form of a powdered or fritted oxide, or phosphorus can be added to the paste by way of phosphate esters and other organophosphorus compounds. More simply, phosphorus can be added as a coating to silver and/or nickel and or silver/nickel alloy particles prior to making a paste. In such case, prior to pasting, the silver and/or nickel and or silver/nickel alloy particles are mixed with liquid phosphorus and a solvent. For example, a blend of 85 to 95 wt% silver and/or nickel and or silver/nickel alloy particles, 5 to 15 wt % solvent and 0.5 to 10 wt % liquid phosphorus is mixed and the solvent evaporated. Phosphorus coated silver and/or nickel and or silver/nickel alloy particles help ensure intimate mixing of phosphorus and silver and/or nickel and or silver/nickel alloy in the pastes.

Other additives such as fine silicon or carbon powder, or both, can be added to the paste to control the silver reduction and precipitation reaction. The silver precipitation at the interface or in the bulk glass can also be controlled by adjusting the firing atmosphere (e.g., firing in flowing N₂ or N₂/H₂/H₂O mixtures). However, no special atmosphere is required. Fine low melting metal additives (i.e., elemental metallic additives as distinct from metal oxides) such as Pb, Bi, In, Ga, Sn, Ni, and Zn or alloys of each with at least one other metal can be added to provide a contact at a lower firing temperature, or to widen the firing window. Typically such metal additions are present at a rate of less than 1 wt% of the conductive metal portion of the pastes herein. Organometallic compounds providing aluminum, barium, bismuth, magnesium, zinc, strontium and potassium may be used, such as, for example, the acetates, acrylates, formates, neodeconates, methoxides, ethoxides, methoxyethoxides, and stearates of the named metals. Potassium silicate is also a suitable source of potassium.

A mixture of (a) glasses or a mixture of (b) glasses and crystalline additives or a mixture of (c) one or more crystalline additives can be used to formulate a glass component in the desired compositional range. The goal is to reduce the contact resistance and improve the solar cell electrical performance. For example, crystalline materials such as Bi₂O₃ Sb₂O₃, Sb₂O₅, In₂O₃, Ga₂O₃, SnO, MgO, ZnO, Cr₂O₃, Fe₂O₃, Pb₃O₄, PbO, SiO₂, ZrO₂, V₂O₅, Al₂O₃, B₂O₃, and Ta₂O₅ may be added to the glass component to adjust contact properties. The foregoing oxides may be added in glassy (i.e., non-crystalline) form as well. Combinations and reaction products of the aforementioned oxides can also be suitable to design a glass component with desired characteristics. For example, low melting lead silicates, either crystalline or glassy, formed by the reaction of PbO and SiO₂ such as 4PbO•SiO₂, 3PbO•SiO₂, 2PbO•SiO₂, 3PbO•2SiO₂, and PbO•SiO₂, either singly or in mixtures can be used to formulate a glass component. Other reaction products of the aforementioned oxides such as ZnO•SiO₂ and ZrO₂•SiO₂ may also be used. However, the total amounts of the above oxides must fall within the ranges specified for various embodiments disclosed elsewhere herein.

The inventors herein have also found that certain glasses containing oxides of hafnium (HfO₂), indium (In₂O₃), and/or gallium (Ga₂O₃) increase both the size and quantity of the conductive metal islands. Hence, up to 15 mol% of HfO₂ and/or In₂O₃ and/or Ga₂O₃ may be included in the glass component.

Oxides of tantalum and molybdenum reduce glass viscosity and surface tension of the glass during firing, facilitating better wetting of the wafer by the molten glass. Accordingly, up to 10 mol% Ta₂O₅, and up to 3 mol% MoO₃ can be included in the glass component.

Kinetics of silver dissolution and precipitation from the glass compositions can be altered by the presence of alkali metal oxides. In that regard, the compositions of the invention may further comprise oxides of alkali metals, for example Na₂O, K₂O, and Li₂O and combinations thereof. In particular, the glass components of certain embodiments herein may contain from 0.1 to 15 mol% Na₂O + K₂O + Li₂O, or more preferably from 0.1 to 5 mol% Na₂O + K₂O + Li₂O.

**Organic Vehicle.** The vehicle or carrier for most conductive compositions is typically a solution of a resin dissolved in a solvent and, frequently, a solvent solution containing both resin and a thixotropic agent. The solvent usually boils from 130°C to 350°C. The most frequently used resin for this purpose is ethyl cellulose. However, resins such as ethyl hydroxyethyl cellulose, wood rosin, mixtures of ethyl cellulose and phenolic resins, polymethacrylates of lower alcohols and the monobutyl ether of ethylene glycol monoacetate can also be used.

The most widely used solvents for thick film applications are terpenes such as alpha- or beta-terpineol or higher boiling alcohols such as Dowanol® (diethylene glycol monoethyl ether), or mixtures thereof with other solvents such as butyl Carbitol® (diethylene glycol monobutyl ether); dibutyl Carbitol® (diethylene glycol dibutyl ether), butyl Carbitol® acetate (diethylene glycol monobutyl ether acetate), hexylene glycol, Texanol® (2,2,4-trimethyl-1,3-pentanediol monoisobutyrate), as well as other alcohol esters, kerosene, and dibutyl phthalate. The vehicle can contain organometallic compounds, for example those based on nickel, phosphorus or silver, to modify the contact. Various combinations of these and other solvents can be formulated to obtain the desired viscosity and volatility requirements for each application. Other dispersants, surfactants and rheology modifiers, which are commonly used in thick film paste formulations, may be included.

Products useful in the organic carrier may be obtained commercially under any of the following trademarks: Texanol® (Eastman Chemical Company, Kingsport, TN); Dowanol® and Carbitol® (Dow Chemical Co., Midland, MI); Triton® (Union Carbide Division of Dow Chemical Co., Midland, MI), Thixatrol® (Elementis Company, Hightstown NJ), and Diffusol® (Transene Co. Inc., Danvers, MA), Ethyl Cellulose (Dow Chemical Company, Midland, MI), Terpineol, (Hercules Inc., Wilmington, DE). N-Diffusol® is a stabilized liquid preparation containing an n-type diffusant with a diffusion coefficient similar to that of elemental phosphorus.

Among commonly used organic thixotropic agents is hydrogenated castor oil and derivatives thereof. A thixotrope is not always necessary because the solvent/resin properties coupled with the shear thinning inherent in any suspension may alone be suitable in this regard. Furthermore, wetting agents may be employed such as fatty acid esters, e.g., N-tallow-1,3-diaminopropane di-oleate; N-tallow trimethylene diamine diacetate; N-coco trimethylene diamine, beta diamines; N-oleyl trimethylene diamine; N-tallow trimethylene diamine; and N-tallow trimethylene diamine dioleate, and combinations thereof.

In the Experimental Examples that follow, the organic vehicle is a blend of Ethyl Cellulose Std. 4 - 0.45%; Ethyl Cellulose Std. 45 - 1.28%; Thixatrol® ST - 0.3%; Triton® X-100- 0.18%; N-Diffusol® 0.5%; Dowanol® DB - 8.45%; and Terpineol - 3.84%, the percentages being by weight. These weight percentages add up to the 15 wt% of the Organic Vehicle in tables 8 and 9. For entries with more than 15 wt% Organic Vehicle, the additional amount is made up by a further portion of Dowanol® DB.

**Paste Preparation.** The paste according to the invention may be conveniently prepared on a three-roll mill. The amount and type of carrier utilized are determined mainly by the final desired formulation viscosity, fineness of grind of the paste, and the desired wet print thickness. In preparing compositions according to the invention, the particulate inorganic solids are mixed with the carrier and dispersed with suitable equipment, such as a three-roll mill, to form a suspension, resulting in a composition for which the viscosity will be in the range of 100 to 500 kcps, preferably 300 to 400 kcps, at a shear rate of 9.6 sec⁻¹ as determined on a Brookfield viscometer HBT, spindle 14, measured at 25°C.

**Printing and Firing of the Paste.** The aforementioned paste compositions may be used in a process to make a solar cell contact or other solar cell components. The method of making solar cell contacts comprises (1) applying a silver- and nickel-containing paste to a silicon substrate, (2) drying the paste, and (3) firing the paste to sinter the metal and make contact to silicon. The printed pattern of the paste is fired at a suitable temperature, such as 650 to 1000°C furnace set temperature, or 550 to 850°C wafer temperature. Preferably, the furnace set temperature is 750 to 930°C, and the paste is fired in air. The antireflective SiNₓ layer is believed to be oxidized and corroded by the glass during firing and Ag/Si islands are formed on reaction with the Si substrate, which are epitaxially bonded to silicon. Firing conditions are chosen to produce a sufficient density of conductive metal/Si islands on the silicon wafer at the silicon/paste interface, leading to a low resistivity, contact thereby producing a high efficiency, high-fill factor solar cell.

A typical ARC is made of a silicon compound such as silicon nitride, generically SiN_{X}, such as Si₃N₄. This layer acts as an insulator, which tends to increase the contact resistance. Corrosion of this ARC layer by the glass component is hence a necessary step in front contact formation. The inventors herein have discovered that reducing the resistance between the silicon wafer and the paste is facilitated by the formation of epitaxial silver/silicon conductive islands at the interface. That is, the silver islands on silicon assume the same crystalline structure as is found in the silicon substrate. When such an epitaxial silver/silicon interface does not result, the resistance at that interface becomes unacceptably high. Until now, the processing conditions to achieve a low resistance epitaxial silver/silicon interface have been very narrow and difficult to achieve. The pastes and processes herein now make it possible to produce an epitaxial silver/silicon interface leading to a contact having low resistance under broad processing conditions-a minimum firing temperature as low as 650 °C, but which can be fired up to 850 °C (wafer temperature). The pastes herein can be fired in air.

**Method of Contact Production.** A solar cell contact according to the invention may be produced by applying any conductive paste disclosed herein to a substrate, for example by screen-printing, to a desired wet thickness, e.g., from about 40 to about 80 microns. Automatic screen-printing techniques can be employed using a 200-280 mesh screen. The printed pattern is then dried at 200°C or less, preferably about 125 to about 175 °C for about 5-15 minutes before firing. The dry printed pattern can be fired for as little as 1 second up to about 30 seconds at peak temperature, in a belt conveyor furnace in air. During firing, the glass is fused and the metal is sintered.

An embodiment of the invention is a solar cell including a front contact, said front contact formed by firing a paste composition comprising a glass portion and a conductive metal portion, said conductive metal portion comprising silver and at least about 1 wt% nickel.

Referring now to FIGS. 1A-1E, a solar cell front contact generally can be produced by applying any silver-based paste to a solar grade Si wafer. In particular, FIG. 1A schematically shows a step in which a substrate of single-crystal silicon or multicrystalline silicon is provided, typically with a textured surface which reduces light reflection. In the case of solar cells, substrates are often used as sliced from ingots which have been formed from pulling or casting processes. Substrate surface damage caused by tools such as a wire saw used for slicing and contamination from the wafer slicing step are typically removed by etching away about 10 to 20 microns of the substrate surface using an aqueous alkali solution such as KOH or NaOH, or using a mixture of HF and HNO₃. The substrate optionally may be washed with a mixture of HCl and H₂O₂ to remove heavy metals such as iron that may adhere to the substrate surface. An antireflective textured surface is sometimes formed thereafter using, for example, an aqueous alkali solution such as aqueous potassium hydroxide or aqueous sodium hydroxide. This resulting substrate, **10,** is depicted with exaggerated thickness dimensions, as a typical silicon wafer is ca. 200 microns thick.

Figure 1B schematically shows that, when a p-type substrate is used, an n-type layer **20** is formed to create a p-n junction. A phosphorus diffusion layer is supplied in any of a variety of suitable forms, including phosphorus oxychloride (POCl₃), organophosphorus compounds, and others disclosed herein. The phosphorus source may be selectively applied to only one side of the silicon wafer. The depth of the diffusion layer can be varied by controlling the diffusion temperature and time, is generally about 0.3 to 0.5 microns, and has a sheet resistivity of about 40 to about 100 ohms per square. The phosphorus source may include phosphorus-containing liquid coating material such as phosphosilicate glass (PSG) is applied onto only one surface of the substrate by a process such as spin coating, where diffusion is effected by annealing under suitable conditions.

Next, in FIG. 1C, an antireflective coating (ARC)/passivating film **30,** which may be SiNₓ, TiO₂ or SiO₂, is formed on the above-described n-type diffusion layer, **20.** Silicon nitride film is sometimes expressed as SiN_{X}:H to emphasize passivation by hydrogen. The ARC **30** reduces the surface reflectance of the solar cell to incident light, increasing the electrical current generated. The thickness of ARC **30** depends on its refractive index, although a thickness of about 700 to 900 Å is suitable for a refractive index of about 1.9 to 2.0. The ARC may be formed by a variety of procedures including low-pressure CVD, plasma CVD, or thermal CVD. When thermal CVD is used to form a SiNₓ coating, the starting materials are often dichlorosilane (SiCl₂H₂) and ammonia (NH₃) gas, and film formation is carried out at a temperature of at least 700° C. When thermal CVD is used, pyrolysis of the starting gases at the high temperature results in the presence of substantially no hydrogen in the silicon nitride film, giving a substantially stoichiometric compositional ratio between the silicon and the nitrogen-Si₃N₄. Other methods of forming an ARC are suitable.

As shown in FIG. 1D, a back side silver/aluminum paste **70** is then screen printed on the backside of the substrate **10,** leaving gaps therebetween, to form electrodes. The paste **70** is dried at ca. 125 °C for ca. 10 minutes. Other drying times and temperatures are possible so long as the paste vehicle is merely dried of solvent, but not combusted or removed at this stage. Next, an aluminum/nickel or aluminum/nickel-alloy paste 80 is printed also on the p-side of wafer 10, and dried similarly to that described above. The back contact is largely covered with the aluminum/nickel paste, to a wet thickness of 30 to 50 microns, owing in part to the need to form a thicker p+ layer **40.** A front side silver or silver/nickel or silver/nickel-alloy paste **500** is printed on the ARC **30** for the front electrodes. The pastes are then dried.

The wafer bearing the dried pastes is then fired in an infrared belt furnace, using an air atmosphere, at a furnace set temperature of about 650° C to about 1000° C for a period of from about one to several minutes. The firing is generally carried out according to a temperature profile that will allow burnout of the organic matter at about 300°C to about 550°C, a period of peak furnace set temperature of about 650°C to about 1000°C, lasting as little as about 1 second, although longer firing times as high as 1, 3, or 5 minutes are possible when firing at lower temperatures. Firing is typically done in an air atmosphere. For example a three-zone firing profile may be used, with a belt speed of about 1 to about 4 meters (40-160 inches) per minute, preferably 3 meters/minute (about 120 inches/minute). In a preferred example, zone 1 is 7 inches (18 cm) long, zone 2 is 16 inches (40 cm) long, and zone 3 is 7 inches (18 cm) long. The temperature in each successive zone is typically, though not always, higher than the previous, for example, 700-790°C in zone 1, 800-850°C in zone 2, and 800-970°C in zone 3. Naturally, firing arrangements having more than 3 zones are envisioned by the invention, including 4, 5, 6, or 7, zones or more, each with zone lengths of 5 to 20 inches and firing temperatures of 650 to 1000°C.

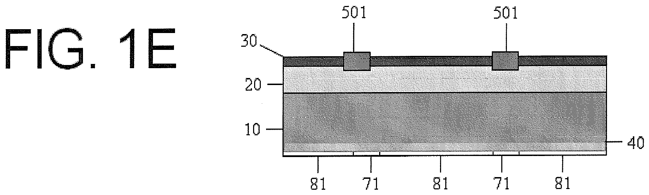

Consequently, as schematically shown in FIG. 1E, aluminum/nickel or aluminum/nickel alloy from the paste **80** melts and reacts with the silicon wafer **10,** during firing, then solidifies to form a partial p+ layer **40** containing a high concentration of A1 or Al/Ni dopant. An exemplary commercially available backside aluminum paste is Ferro AL53-120 Standard. This layer is generally called the back surface field (BSF) layer, and helps to improve the energy conversion efficiency of the solar cell.

Simultaneously, the backside silver/nickel paste or silver/nickel alloy paste **70** is fired becoming a silver/nickel or silver/nickel alloy back contact **71.** An exemplary backside silver based paste is Ferro PS 33-602. The back side silver/nickel or silver/nickel-alloy paste areas are used for tab attachment during module fabrication. Also during firing, the front side silver/nickel or silver/nickel-alloy paste **500** sinters and penetrates (i.e., fires through) the silicon nitride layer **30** and thereby makes electrical contact with the n-type layer **20,** as shown by electrodes **501** in FIG. IE.

Processes of making the pastes, solar cell contacts and solar cells disclosed herein are envisioned as embodiments of the invention.

**Experimental Examples:** Polycrystalline silicon wafers, 10.0 cm x 10.0 cm, thickness of 150 to 300 microns were coated with a silicon nitride antireflective coating. The sheet resistivity of these wafers was about 30 Ω/square. Glass compositions B and D from Table 7 were formulated into pastes in accordance with the formulations of Tables 8 and 9, below.

Examples using the paste compositions of Tables 8 and 9 were printed using a 280 mesh screen with∼100 micron openings for front contact finger lines and ∼2.5 mm spacing between the lines. The symbol "∼" means "approximately." Samples were dried at about 150°C for about 10 minutes after printing the front contacts. The printed wafers were co-fired in air using a 3-zone infrared (IR) belt furnace from RTC, with a belt speed of about 3 meters (120") per minute, with temperature set points of 830°C in all three zones. The zones were 7", 16", and 7" long, respectively. The fired finger width for most samples was about 120 to about 170 microns, and the fired thickness was about 10 to 15 microns.

Electrical performance of the solar cells was measured with a solar tester, Model NCT-M-180A, NPC Incorporated, Dumont, NJ, under AM 1.5 sun conditions, in accordance with ASTM G-173-03. The results of this electrical testing for the silver powder examples of Table 8 and the silver flake samples of Table 9 are presented in the respective tables. Jsc means short circuit current density, measured at zero output voltage; Voc means open circuit voltage measured at zero output current; R_{S} and Rₛₕ were previously defined.

It will be appreciated that although the examples herein primarily concern a conductive composition for use in forming a conductor paste for in the formation of solar cell contacts, the present invention also contemplates the use of the principles disclosed herein to form resistor and semiconductor pastes, inks, tapes and the like. Furthermore, such compositions may or may not be considered as materials for use in forming thick films. Thus, applicants' unique conductive compositions may be utilized to form conductive, resistive or semiconducting paths or patterns on substrates. Such conductive composition may assume various forms including an ink, a paste, a tape and the like. Additionally, substrates other than silicon may be employed in connection with the pastes of the present invention. The use of the compositions disclosed herein is also envisioned in a variety of electronic components and devices.

**Table 8. Paste Composition and Electrical Properties. One micron silver powder was used.**

| | **Paste Composition in wt%** | | | | | **Electrical Properties** | | | | | | |
|---|---|---|---|---|---|---|---|---|---|---|---|---|
| **Ex. No** | **Silver** | **Non Silver** | **Glass B** | **Glass D** | **Organic Vehicle** | **Jsc (mA/cm²)** | **Voc (mV)** | **FF** | **EFF (%)** | **Rs (mohm)** | **Rsh (ohm)** | **Non Silver ID** |
| **1** | 80 | 0 | 3.1 | 1.6 | 15.3 | 30.12 | 573.8 | 0.6596 | 11.4011 | 18.5 | 2.1351 | none |
| **2** | 70.3 | 10 | 3.1 | 1.6 | 15 | 30.73 | 577.8 | 0.7493 | 13.3072 | 16.8 | 140.94 | Ni UNP 800 |
| **3** | 60.3 | 20 | 3.1 | 1.6 | 15 | 30.71 | 574.9 | 0.7102 | 12.5383 | 16.0 | 6.8383 | Ni UNP 800 |
| **4** | 50.3 | 30 | 3.1 | 1.6 | 15 | 31.29 | 571.2 | 0.7149 | 12.7764 | 15.4 | 11.332 | Ni UNP 800 |
| **5** | 40.3 | 40 | 3.1 | 1.6 | 15 | 29.29 | 557.1 | 0.4682 | 7.63916 | 29.4 | 1.0775 | Ni UNP 800 |
| **6** | 50.3 | 30 | 3.1 | 1.6 | 15 | 31.84 | 583.3 | 0.7306 | 13.5716 | 13.8 | 4.6422 | Ni 357-6 (Ni-4.1% Al) |
| **7** | 50 | 30 | 3.15 | 1.85 | 15 | 30.57 | 572.2 | 0.7383 | 12.9133 | 14.3 | 2.8925 | Ni 357-6 (Ni-4.1% Al) |
| **8** | 40 | 40 | 3.15 | 1.85 | 15 | 31.59 | 579.1 | 0.6495 | 11.8819 | 26.0 | 9.737 | Ni 357-6 (Ni-4.1% Al) |
| **9** | 30 | 50 | 3.15 | 1.85 | 15 | 29.81 | 561.8 | 0.6782 | 11.3572 | 18.2 | 2.3121 | Ni 357-6 (Ni-4.1% Al) |
| **10** | 40 | 40 | 3.15 | 1.85 | 15 | 30.74 | 569.5 | 0.7404 | 12.9609 | 16.2 | 13.645 | Ecka 302 (Ni-5.1% Al) |
| **11** | 30 | 50 | 3.15 | 1.85 | 15 | 30.59 | 579.1 | 0.7305 | 12.9393 | 16.0 | 26.191 | Ecka 302 (Ni-5.1% Al) |
| **12** | 11 | 69 | 3.15 | 1.85 | 15 | 31.23 | 572.3 | 0.6767 | 12.0956 | 22.5 | 16.102 | Ecka 302 (Ni-5.1% Al) |
| **13** | 30 | 50 | 3.15 | 1.85 | 15 | 30.56 | 576.1 | 0.7535 | 13.2643 | 13.0 | 65.634 | Ecka 329 (Ni-9% Al) |
| **14** | 30 | 50 | 3.15 | 1.85 | 15 | 30.63 | 580.3 | 0.6782 | 12.0562 | 17.9 | 8.7918 | Ecka 304 (Ni-20% Al) |
| **15** | 30 | 50 | 3.15 | 1.85 | 15 | 31.33 | 580.8 | 0.6522 | 11.8704 | 21.4 | 1.8431 | Ni 105 (80% Ni & 20% Cr) |
| **16** | 30 | 50 | 3.15 | 1.85 | 15 | 31.38 | 564.9 | 0.7107 | 12.5981 | 19.0 | 6.3494 | Ni 343 (Ni-22% Cr-10% Al) |
| **17** | 30 | 50 | 3.15 | 1.85 | 15 | 31.36 | 576.0 | 0.6681 | 12.0658 | 21.7 | 52.636 | Ni 246-3 (Ni-32% Cr-12% Al) |
| **18** | 50 | 30 | 3.1 | 1.6 | 15.3 | 30.91 | 575.6 | 0.7013 | 12.4761 | 16.2 | 1.7696 | Ecka 514 (Ni-18.6% Cr/1.2% Si/0.3% Fe) |
| **19** | 50 | 30 | 3.1 | 1.6 | 15.3 | 30.59 | 574.8 | 0.7003 | 12.3122 | 11.7 | 9.7742 | Ecka 666 (Ni-51.1% Cr/1.6% Si |
| **20** | 50 | 30 | 3.1 | 1.6 | 15.3 | 30.65 | 577.7 | 0.6104 | 10.8084 | 34.0 | 3.1882 | IN 625 (Ni-21.5% Cr/0.35% Si/2.3% Fe/9.2% Mo/3.4% Nb/Ta/0.3% Mn |

**Table 9. Paste Composition and Electrical Properties. One micron Silver flakes were used.**

| | **Paste Composition in wt%** | | | | | **Electrical Properties** | | | | | | |
|---|---|---|---|---|---|---|---|---|---|---|---|---|
| **Ex. No.** | **Silver** | **Non Silver** | **Glass B** | **Glass D** | **Organic Vehicle** | **Jsc (mA/cm²)** | **Voc (mV)** | **FF** | **EFF (%)** | **Rs (mohm)** | **Rsh (ohm)** | **Non Silver ID** |
| 1 | 80 | 0 | 3.15 | 1.85 | 15 | 32.36 | 580.04 | 0.73757 | 13.84234 | 13.50 | 4.57696 | none |
| 2 | 70 | 10 | 3.15 | 1.85 | 15 | 32.37 | 583.93 | 0.74588 | 14.10064 | 9.93 | 10.30554 | Ni UNP 800 |
| 3 | 60 | 20 | 3.15 | 1.85 | 15 | 32.74 | 581.84 | 0.70315 | 13.39596 | 22.34 | 323.6 | Ni UNP 800 |
| 4 | 50 | 30 | 3.15 | 1.85 | 15 | 32.38 | 578.24 | 0.66788 | 12.50558 | 19.07 | 25.52586 | Ni UNP 800 |
| **5** | 40 | 40 | 3.15 | 1.85 | 15 | 29.75 | 561.69 | 0.56411 | 9.42789 | 27.21 | 1.37884 | Ni UNP 800 |
| **6** | 75 | 5 | 3.15 | 1.85 | 15 | 31.75 | 578.32 | 0.75236 | 13.81656 | 13.39 | 38.04915 | SB 81 (90Ni-10Al alloy) |
| **7** | 70 | 10 | 3.15 | 1.85 | 15 | 32.33 | 584.92 | 0.74357 | 14.06256 | 16.02 | 13.60644 | SB 81 (90Ni-10Al alloy) |
| **8** | 60 | 20 | 3.15 | 1.85 | 15 | 32.84 | 587.43 | 0.73444 | 14.16701 | 16.16 | 21.93512 | SB 81 (90Ni-10Al alloy) |
| **9** | 50 | 30 | 3.15 | 1.85 | 15 | 33.13 | 583.74 | 0.73112 | 14.13852 | 14.67 | 16.66992 | SB 81 (90Ni-10Al alloy) |
| **10** | 40 | 40 | 3.15 | 1.85 | 15 | 31.36 | 576.58 | 0.65834 | 11.90236 | 21.93 | 13.82267 | SB 81 (90Ni-10Al alloy) |
| **11** | 30 | 50 | 3.15 | 1.85 | 15 | 31.34 | 580.42 | 0.55058 | 10.01466 | 26.77 | 7.0507 | SB 81 (90Ni-10Al alloy) |
| **12** | 75 | 5 | 3.15 | 1.85 | 15 | 30.76 | 562.38 | 0.73864 | 12.77647 | 17.39 | 24.19194 | NiCoCrAlY (Ni-25Co-9Cr-13.7Al-0.48Y) |
| **13** | 70 | 10 | 3.15 | 1.85 | 15 | 32.05 | 581.23 | 0.73665 | 13.72358 | 15.35 | 18.6682 | NiCoCrAlY |
| **14** | 60 | 20 | 3.15 | 1.85 | 15 | 31.73 | 575.79 | 0.63806 | 11.6573 | 18.21 | 1.87227 | NiCoCrAlY |
| **15** | 50 | 30 | 3.15 | 1.85 | 15 | 32.30 | 576.96 | 0.7369 | 13.7335 | 13.15 | 48.36022 | NiCoCrAlY |
| **16** | 40 | 40 | 3.15 | 1.85 | 15 | 31.46 | 569.37 | 0.68245 | 12.22455 | 18.85 | 37.88136 | NiCoCrAlY |
| **17** | 30 | 50 | 3.15 | 1.85 | 15 | 31.09 | 563.65 | 0.50808 | 8.90239 | 40.36 | 7.45084 | NiCoCrAlY |

## Claims

1. A thick film paste comprising a glass portion and a conductive metal portion, said conductive metal portion comprising:
a. from 10 to 99 wt% silver and
b. from 1 to 90 wt% of a nickel alloy selected from the group consisting of a nickel-aluminum alloy, a nickel-chromium alloy, and a nickel-aluminum-chromium alloy, and combinations thereof.

2. The thick film paste of claim 1 wherein the nickel alloy comprises 1 to 25 wt% aluminum, 0 to 30 wt% chromium, and nickel.

3. The thick film paste of claim 1, wherein the nickel alloy is a nickel-chromium alloy, said nickel-chromium alloy comprising 1 to 60 wt% chromium.

4. The thick film paste of claim 2, wherein said nickel alloy further includes an element selected from the group consisting of cobalt, iron, silicon, molybdenum, manganese, and combinations thereof.

5. The thick film paste of claim 2, wherein said nickel alloy further comprises an element selected from the group consisting of vanadium, antimony, tantalum, niobium, and combinations thereof.

6. The thick film paste of claim 1, wherein the nickel alloy is a nickel-aluminum alloy, said nickel-aluminum alloy comprising 75 to 99 wt% nickel and 1 to 25 wt% aluminum.

7. The thick film paste of claim 1, wherein the conductive metal portion comprises:
a. from 20 to 90 wt% silver, and
b. from 10 to 80 wt% of a nickel alloy selected from the group consisting of a nickel-aluminum alloy, a nickel-chromium alloy, and a nickel-aluminum-chromium alloy, and combinations thereof.

8. The thick film paste of claim 1, wherein the conductive metal portion comprises
a. 37.5 to 75 wt% silver and
b. 25 to 62.5 wt% of a nickel alloy.

9. The thick film paste of claim 1, wherein the conductive metal portion comprises
a. 13.8 to 87.5 wt% silver and
b. 12.5 to 86.2 wt% of a nickel alloy selected from the group consisting of nickel-aluminum, nickel chromium, nickel-aluminum-chromium, and combinations thereof.

10. The thick film paste of claim 9, wherein the nickel alloy is a nickel-aluminum alloy, said nickel-aluminum alloy comprising 1 to 20 wt% aluminum and 80 to 99 wt% nickel.

11. A thick film paste of claim 1 comprising a partially crystallizing glass.

12. A thick film paste of claim 1 comprising:
a glass portion including frit particles having a particle size no greater than 2 microns, the glass portion including at least one partially crystallizing glass frit.

13. A solar cell including a front contact, said front contact formed by firing a thick film paste composition according to any of claims 1 to 12.

14. A process for making a solar cell contact according to claim 13, comprising
a. applying a thick film paste according to any of claims 1 to 12 to a silicon wafer,
b. firing the silicon wafer at a time and temperature sufficient to sinter the metal portion and fuse the glass portion.

## Patentansprüche

1. Dickschichtpaste mit einem Glasanteil und einem leitfähigen Metallanteil, wobei der leitfähige Metallanteil aufweist:
a. von 10 bis 90 Gew.-% Silber und
b. von 1 bis 90 Gew.-% einer Nickellegierung, die ausgewählt ist aus der Gruppe, die aus einer Nickel-Aluminium-Legierung, einer Nickel-Chrom-Legierung und einer Nickel-Aluminium-Chrom-Legierung und Kombinationen daraus besteht.

2. Dickschichtpaste gemäß Anspruch 1, wobei die Nickellegierung 1 bis 25 Gew.-% Aluminium, 0 bis 30 Gew.-% Chrom und Nickel aufweist.

3. Dickschichtpaste gemäß Anspruch 1, wobei die Nickellegierung eine Nickel-Chrom-Legierung ist, wobei diese Nickel-Chrom-Legierung 1 bis 60 Gew.-% Chrom aufweist.

4. Dickschichtpaste gemäß Anspruch 2, wobei die Nickellegierung ferner ein Element aufweist, das aus der Gruppe ausgewählt ist, die aus Kobalt, Eisen, Silikon, Molybdän, Mangan und Kombinationen daraus besteht.

5. Dickschichtpaste gemäß Anspruch 2, wobei die Nickellegierung ferner ein Element aufweist, das aus der Gruppe ausgewählt ist, die aus Vanadium, Antimon, Tantal, Niobium und Kombinationen daraus besteht.

6. Dickschichtpaste gemäß Anspruch 1, wobei die Nickellegierung eine Nickel-Aluminium-Legierung ist, wobei diese Nickel-Aluminium-Legierung 75 bis 99 Gew.-% Nickel und 1 bis 25 Gew,-% Aluminium aufweist.

7. Dickschichtpaste gemäß Anspruch 1, wobei der leitfähige Metallanteil aufweist:
a. von 20 bis 90 Gew.-% Silber, und
b. von 10 bis 80 Gew.-% einer Nickellegierung, die ausgewählt ist aus der Gruppe, die aus einer Nickel-Aluminium-Legierung, einer Nickel-Chrom-Legierung und einer Nickel-Aluminium-Chrom-Legierung und Kombinationen daraus besteht.

8. Dickschichtpaste gemäß Anspruch 1, wobei der leitfähige Metallanteil aufweist:
a. von 37,5 bis 75 Gew.-% Silber und
b. 25 bis 62,5 Gew.-% einer Nickellegierung.

9. Dickschichtpaste gemäß Anspruch 1, wobei der leitfähige Metallanteil aufweist:
a. 13,8 bis 87,5 Gew.-% Silber und
b. 12,5 bis 86,2 Gew.-% einer Nickellegierung, die ausgewählt ist aus der Gruppe, die aus Nickel-Aluminium, Nickel-Chrom, Nickel-Aluminium-Chrom und Kombinationen daraus besteht.

10. Dickschichtpaste gemäß Anspruch 9, wobei die Nickellegierung eine Nickel-Aluminium-Legierung ist, wobei diese Nickel-Aluminium-Legierung 1 bis 20 Gew.-% Aluminium und 80 bis 99 Gew,-% Nickel ausweist.

11. Dickschichtpaste gemäß Anspruch 1, welche ein teilweise kristallisierendes Glas aufweist.

12. Dickschichtpaste gemäß Anspruch 1 aufweisend:
einen Glasanteil, der Sinterpartikel mit einer Partikelgröße von nicht über 2 Mikrometer aufweist, wobei der Glasanteil zumindest eine teilweise kristallisierende Glasfritte aufweist.

13. Solarzelle, die einen Vorderseitenkontakt aufweist, wobei dieser Vorderseitenkontakt durch Brennen einer Dickschichtpastenzusammensetzung gemäß irgendeinem der Ansprüche 1 bis 12 gebildet wird.

14. Verfahren zur Herstellung eines Solarzellenkontakts gemäß Anspruch 13, aufweisend:
a. Aufbringen einer Dickschichtpaste gemäß irgendeinem der Ansprüche 1 bis 12 auf einen Siliziumwafer,
b. Brennen des Siliziumwafers über einen Zeitraum und bei einer Temperatur, die ausreichen, um den Metallanteil zu sintern und den Glasanteil zu schmelzen.

## Revendications

1. Pâte pour couches épaisses comprenant une proportion de verre et une proportion de métal conducteur, ladite proportion de métal conducteur comprenant :
a. de 10 à 99 % en poids d'argent et
b. de 1 à 90 % en poids d'un alliage de nickel sélectionné dans le groupe, qui consiste en un alliage de nickel-aluminium, un alliage nickel-chrome, et un alliage nickel-aluminium-chrome et en des combinaisons de ceux-ci.

2. Pâte pour couches épaisses selon la revendication 1, dans laquelle l'alliage de nickel comprend 1 à 25 % en poids d'aluminium, 0 à 30 % en poids de chrome et du nickel.

3. Pâte pour couches épaisses selon la revendication 1, dans laquelle l'alliage de nickel est un alliage nickel-chrome, ledit alliage nickel-chrome comprenant 1 à 60 % en poids de chrome.

4. Pâte pour couches épaisses selon la revendication 2, dans laquelle ledit alliage de nickel comprend en outre un élément sélectionné dans le groupe, qui consiste en cobalt, en fer, en silicone, en molybdène, en manganèse et en des combinaisons de ceux-ci.

5. Pâte pour couches épaisses selon la revendication 2, dans laquelle ledit alliage de nickel comprend en outre un élément sélectionné dans le groupe, qui consiste en vanadium, en antimoine, en tantale, en niobium et en des combinaisons de ceux-ci.

6. Pâte pour couches épaisses selon la revendication 1, dans laquelle ledit alliage de nickel est un alliage nickel-aluminium, ledit alliage nickel-aluminium comprenant 75 à 99 % en poids de nickel et 1 à 25 % en poids d'aluminium.

7. Pâte pour couches épaisses selon la revendication 1, dans laquelle la proportion de métal conducteur comprend :
a. de 20 à 90 % en poids d'argent, et
b. de 10 à 80 % en poids d'un alliage de nickel sélectionné dans le groupe, qui consiste en un alliage de nickel-aluminium, un alliage nickel-chrome et un alliage nickel-aluminium-chrome, et en des combinaisons de ceux-ci.

8. Pâte pour couches épaisses selon la revendication 1, dans laquelle la proportion de métal conducteur comprend :
a. 37,5 à 75 % en poids d'argent, et
b. 25 à 62,5 % en poids d'un alliage de nickel.

9. Pâte pour couches épaisses selon la revendication 1, dans laquelle la proportion de métal conducteur comprend :
a. 13,8 à 87,5 % en poids d'argent, et
b. 12,5 à 86,2 % en poids d'un alliage de nickel sélectionné dans le groupe, qui consiste en nickel-aluminium, en nickel-chrome et en aluminium-chrome, et en des combinaisons de ceux-ci.

10. Pâte pour couches épaisses selon la revendication 9, dans laquelle l'alliage de nickel est un alliage nickel-aluminium, ledit alliage de nickel-aluminium comprenant 1 à 20 % en poids d'aluminium et 80 à 99 % en poids de nickel.

11. Pâte pour couches épaisses selon la revendication 1 comprenant un verre partiellement cristallisant.

12. Pâte pour couches épaisses selon la revendication 1 comprenant :
une proportion de verre comprenant des particules de frittage ayant une taille de particule, qui n'excède pas 2 microns, la proportion de verre comprenant au moins une fritte de verre partiellement cristallisant.

13. Cellule solaire comprenant un contact frontal, ledit contact frontal étant formé en brûlant une composition de pâte pour couches épaisses selon l'une quelconque des revendications 1 à 12.

14. Procédé de fabrication d'un contact de cellule solaire selon la revendication 13, comprenant les étapes de :
a. appliquer une pâte pour couches épaisses selon l'une quelconque des revendications 1 à 12 sur une tranche de silicium,
b. brûler la tranche de silicium pendant une période de temps et à une température, qui sont suffisantes pour le frittage de la proportion de métal et la fusion de la proportion de verre.
